**Europäisches Patentamt**

**European Patent Office**

**Office européen des brevets**

(19)

(11) Veröffentlichungsnummer: **0 104 207**
**B1**

(12) # EUROPÄISCHE PATENTSCHRIFT

(45) Veröffentlichungstag der Patentschrift:
02.07.86

(51) Int. Cl.⁴: **C 30 B 9/00**

(21) Anmeldenummer: 83901056.8

(22) Anmeldetag: 30.03.83

(86) Internationale Anmeldenummer:
**PCT/AT 83/00008**

(87) Internationale Veröffentlichungsnummer:
**WO 83/03431 (13.10.83 Gazette 83/24)**

(54) GRADIENTENVERFAHREN ZUM ZÜCHTEN VON KRISTALLEN AUS FLÜSSIGEN MEDIEN.

(30) Priorität: 30.03.82 AT 1226/82

(43) Veröffentlichungstag der Anmeldung:
04.04.84 Patentblatt 84/14

(45) Bekanntmachung des Hinweises auf die Patenterteilung:
02.07.86 Patentblatt 86/27

(84) Benannte Vertragsstaaten:
**BE CH DE FR GB LI LU NL SE**

(56) Entgegenhaltungen:
**DE-A-2 300 989**
**FR-A-1 293 744**
**US-A-2 875 108**

(73) Patentinhaber: **Knischka Rubine Gesellschaft
m.b.H., Opernring 19, A-1010 Wien (AT)**

(72) Erfinder: **KNISCHKA, Paul Otto, Stelzhamerstrasse
46, A-4400 Steyr (AT)**
Erfinder: **GRENZ, Hans Jürgen, Bülowstrasse 27,
D-8000 München (DE)**

(74) Vertreter: **Hübscher, Gerhard, Dipl.- Ing.,
Patentanwälte Dipl.- Ing. Gerhard Hübscher
Dipl.- Ing. Helmut Hübscher Dipl.- Ing. Heiner
Hübscher Spittelwiese 7, A-4020 Linz (AT)**

EP 0 104 207 B1

LIBER, STOCKHOLM 1986

### Beschreibung

Kristalle werden aus verschiedensten anorganischen, aber auch organischen Verbindungen gezüchtet, wobei für die industrielle Verwertung vor allem ein hoher Reinheitsgrad zur Ausnutzung von physikalischen Effekten und für die Herstellung von Doubles in der Edelsteinbranche eine gute, möglichst naturähnliche und zu unbeschädigten, natürlich gewachsenen Kristallflächen führende Ausbildung der Zuchtresultate angestrebt werden.

Die bekannten Zuchtverfahren benötigen nun alle Keimhalterungen mechanischer Art, soferne sie nicht mit Mikrokeimen, oder bei Verwendung von Makrokeimen mit magnetischen Drehfeldern oder im außerirdischen Milieu arbeiten.

Die Kristallzuchten aus Gel- oder Dampfphasen u. dgl. kommen eventuell ohne Kristallhalter aus, doch wachsen hierbei die entstehenden Kristalle an festen Flächen an und sind dann nach Abtrennung zweifellos beschädigt; dasselbe gilt übrigens auch für Kristalle, die durch Übersättigungen spontan entstehen, und zwar deshalb, weil ab einem kritischen Keimradius $r_k^*$ und darunter die Oberflächenspannungen der Lösungen oder Schmelzen in bezug auf das Keimgewicht überwiegen und so diese Mikrokeime immer und bei jedem Dichteverhältnis von Keim zu Lösungsmittel auf der Oberfläche desselben schwimmen. Dieses kleine Keimgewicht solcher "nuclei" ist auch dafür zuständig, daß die spontanen Keimbildungen immer dort auftreten, wo Übersättigung herrscht und nicht dort, wo "oben" oder "unten" ist.

Bisher müssen alle Keime, die größer als $r_k^*$ sind, mittels Keimhalter in ihrer Lage derart präzisiert werden, daß sie

a) nicht nach unten fallen oder

b) nicht am Meniskus des Lösungsmittels schwimmen, je nachdem, ob ihre Dichte ($d_k$) größer oder kleiner als die Dichte des Lösungs ($d_L$)- oder Schmelzmittels ($d_s$) ist.

Um die Ausbildung der zu züchtenden Kristalle zu verbessern, wurde gemäß der DE-A-2 300 989 auch schon vorgeschlagen, die Kristalle aus einer zusammenhängenden Substanzmasse zu züchten, die selbst in einem flüssigen Medium enthalten ist, wobei dieses Medium und die Substanzmasse gleiche oder etwa gleiche Dichte besitzen können. Dadurch sollen für die Kristallausbildung nachteilige Konvektionsströmungen in der Substanzmasse verhindert und gleichzeitig eine allseitige Wärmezufuhr zur Substanzmasse durch das diese umhüllende Medium erreicht werden. Allerdings gibt es auch hier keine Änderung des eigentlichen Zuchtverfahrens und das Ziehen der Kristalle aus der Substanzmasse bedarf wie bisher der Keimhalterungen für die Keimkristalle.

Aufgabe der Erfindung ist es daher, ein Verfahren anzugeben, das Zuchtmöglichkeiten anbietet, bei denen ein oder mehrere Keime ohne Keimhalterungen verwendet werden können, und gelöst wird diese Aufgabe dadurch, daß die Züchtung in einem Lösungsmittel erfolgt, dessen Dichte gleich oder ungefähr gleich der Dichte des gezüchteten Kristalls bei der jeweiligen Zuchttemperatur und dem jeweiligen Zuchtdruck ist ($d_k = d_s = d_L$), wodurch die Keime in der Substanzmasse, in der Schmelze, in der Nährlösung od. dgl. schweben.

Es ist ein Gradientenverfahren durchführbar, das die Zucht von Kristallen mit Edelsteinqualität unter völliger oder nahezu völliger Inhibierung der Gravitationswirkung im irdischen Milieu erlaubt. Da die Dichte flüssiger Lösungsmittel immer wesentlich stärker temperaturabhängig sein wird als die Dichte fester Substanzen (Keime), kann angenommen werden, daß in einem Gradientenverfahren der untere Teil des Zuchtraumes etwas wärmer als der mittlere Teil und der obere Teil hingegen etwas kühler als letzterer sein wird ($t_{su} > t_{sm} > t_{so}$). Wenn die Nährsubstanz im unteren, wärmeren Teil etabliert ist, dann ist $t_n = t_{sm} + \Delta t$, wobei $t_n$...Temperatur des Nährraumes in °C der Lösung (Schmelze), $\Delta t$....Temperaturgradient in °C der Lösung (Schmelze), $t_{sm}$...Temperatur im mittleren Keimraum in °C der Lösung (Schmelze), $t_{su}$...Temperatur im unteren Keimraum in °C der Lösung (Schmelze) und $t_{so}$...Temperatur im oberen Keimraum in °C der Lösung (Schmelze) ist.

Da bei allen Gradientenverfahren mit höchst präzis konstant gehaltenen Temperaturen gearbeitet wird, kann für die Dichten der flüssigen Lösungsmittel im Keimraum aus $t_{su} > t_{sm} > t_{so}$ gefolgert werden (bei flüssigen Salzgemischen und positiven Ausdehnungskoeffizienten), daß $d_{su} < d_{sm} < d_{so}$, die Dichten der flüssigen Salzgemische ($d_s$) im unteren Teil kleiner und nach oben zu größer werden. Daraus folgert, daß ein Keim mit der Dichte $d_k = d_{sm}$ in der Mitte des Keimraumes schweben muß. Durch Konvektionsströmungen kann der Keim aber beispielsweise etwas nach unten kommen, wo er, da nun ja $d_k > d_{sm}$ ist, zunächst bliebe, bis er durch weitere Konvektion und auch durch allmähliche Erwärmung des Keims selbst wieder nach oben steigt und nunmehr der obere Platz zugewiesen erschiene, weil ja nun $d_k < d_{so}$ ist. Aber auch von dort her wird die Konvektion seine Lage (unter anderen) wieder einmal nach unten verändern wollen, was bei nunmehriger kleiner Abkühlung des Keims als zusätzliche Wirkung leicht zustande kommt. Damit ist eine zusätzliche Rührwirkung erklärt. Der Regelkreis dieses Rührmechanismus wird invers, wenn das entsprechende Gradientenverfahren ebenfalls mit inversen Lösungs- und Keim-Arrangements arbeitet. Damit kann der Keim oder können die Keime im Lösungsmittelzentrum plaziert werden, ohne daß Keimhalter irgendwelcher Art benötigt werden. Der Rührvorgang selbst wirkt sich höchst positiv auf Homogenität und Schnelligkeit des Wachstums aus.

Wie bei allen Gradientenverfahren wird auch hier der Zucht- vom Nähr-Raum durch ein Prallsieb (baffle) getrennt.

Der technische Fortschritt dieses Patentes ist allein darin zu suchen, daß es die Möglichkeit aufzeigt, auch für relativ schwere Kristalle (d.h., Kristalle mit hoher Dichte!) Nährlösungen zu komponieren, die gleiche Dichte wie der wachsende Kristall bei der gewünschten Zuchttemperatur und dem gewünschten Zuchtdruck ($t_{sm}$, $p_{sm}$) aufweisen.

Aber auch Kristalle relativ kleiner Dichte können von gleich dichten Nährlösungen umschlossen werden. Auch diese werden dann in der entsprechenden Lösung gemäß der erfindungsgemäßen Aussage $d_k \cong d_L$ schweben und durch Konvektionsströmungen gerührt werden.

Als Beispiel sei angeführt:

Korund, also auch Rubin weist eine Dichte bei Raumtemperatur von $d_k$ = 3,99 bzw. 4,0 auf. Schon seit Jahrzehnten ist bekannt, daß sowohl PbO ($d_{sl}$ = 9,36), als auch $B_2O_3$ ($d_{s2}$ = 1,844), im Verein mit ($Al_2O_3$,$Cr_2O_3$), also Rubin, kongruentes Schmelzverhalten zeigen. Nun ist es leicht einsichtig, daß bei einem entsprechenden Mol%- oder Gew%-Satz dieser beiden Verbindungen PbO und $B_2O_3$ die Dichte von 3,99 wird auftreten müssen. Natürlich bei einer gewissen Temperatur $t_{sm}$ und einem gewissen Druck $p_{sm}$. Darüber hinaus ist nur dann auf ein azeotropes Salzgemisch zu achten, wenn die Zucht in nicht abgedichteten Zuchträumen erfolgt. Bei nichtazeotropenn Verhalten eines Salzgemisches würden nämlich in offenen Systemen die Einzelkomponenten der Mischung ihren prozentualen Anteil und somit die Gesamtdichte des Salzgemisches ändenn, wodurch in weiterer Folge $d_k \neq d_L$ wäre. Es gibt unzählige Kompositionsmöglichkeiten für die Durchführung des erfindungsgemäßen Verfahrens, und es muß sich keineswegs nur um die Komposition von lediglich zwei Salzen handeln, sondern es können auch beliebig viele Salzgemische Verwendung finden, wobei ihre Summendichte $d_L$ wiederum gleich $d_k$ sein muß. Dabei können manche Salze sehr entscheidend für die Dichte, andere (die schon ungefähr gleiche Dichte wie der Keim aufweisen) wieder mehr für die Ausbildung gewisser Flächen, also für die Isometrie, zuständig sein. Da in einem Lösungsmilieu, in dem auf die schwebenden Keime hin keine Gravitationskräfte mehr einwirken, die sonst unwirksamen Kräfte intermolekularer Form zur Wirkung kommen, werden beispielsweise zwei Keime, welche schweben, auf Grund dieser Kräfte sich so aneinanderlagern und dann auch so verwachsen, daß z.B. ein Zwilling entsteht und bei der Anwesenheit von drei Keimen könnten Drillinge entstehen usw. Da jedoch das Zuwenden gleichorientierter Flächen von schwebenden Keimen von der jeweiligen gegenseitigen Lage, der Rührgeschwindigkeit, des Dipols usw. abhängen wird, ist erst bei genügender Anzahl von schwebenden Keimen orientierte Verwachsung zu erwarten.

**Patentanspruch**

Gradientenverfahren zum Züchten von Kristallen aus flüssigen Medien, dadurch gekennzeichnet, daß die Züchtung in einem Lösungsmittel erfolgt, dessen Dichte ($d_s$, $d_L$) bei der jeweiligen Zuchttemperatur und dem jeweiligen Zuchtdruck gleich oder ungefähr gleich der Dichte des gezüchteten Kristalls ($d_k$) bzw. der gezüchteten Kristalle ($d_k$) ist.

**Claim**

A gradient process of growing crystals in liquid media, characterized in that the crystals are grown in a solvent which at the temperature and the pressure at which the crystals are grown has a density ($d_s$, $d_L$) which is equal or approximately equal to the density ($d_k$) of the grown crystal or crystals.

**Revendication**

Procédé à gradient pour cultiver des cristaux à partir de milieux liquides, caractérisé par le fait que la culture a lieu dans un solvant dont la densité ($d_s$,$d_L$) à la température de culture et à la pression de culture régnant dans chaque cas particulier est égale ou à peu pres égale à la densité du cristal cultivé ($d_k$) ou des cristaux cultivés ($d_k$).